# EUROPÄISCHE PATENTANMELDUNG

(11) **EP 4 579 632 A1**
(43) Veröffentlichungstag der Anmeldung: **02.07.2025**
(21) Anmeldenummer: 24221555.6
(22) Anmeldetag: 19.12.2024
(51) Int. Cl.: G09B 5/04, B42D 1/00, G06F 3/041, G09B 5/06

(54) **BUCH MIT AUDIOAUSGABE UND AUFNAHMEFUNKTION**

(30) Priorität: 28.12.2023 DE 102023136771
(71) Anmelder: JAST Gifts Shenzhen Company Limited, Shenzhen City, Guangdong 518122 (CN)
(72) Erfinder: Chen, Jen-Lin, Cupertino, 95014 (US)
(74) Vertreter: Schneiders & Behrendt Bochum

(57) **Zusammenfassung**

Die Erfindung betrifft ein Buch mit einer Audioausgabe und Audioaufnahmefunktion mit einem vorderen und einem hinteren Buchdeckel (2, 3), einem Buchrücken, mindestens einer Buchseite (4) und mit einer Elektronik, die mindestens einem Sensor (8) umfasst, die in mindestens einer Buchseite (4) oder einem Buchdeckel (2, 3) angeordnet sind, wobei durch den Druck auf einen Sensor (8) die Wiedergabe oder die Aufnahme einer diesem Sensor (8) zuweisbaren Audiodatei aus einem zumindest teilweise beschreibbaren und teilweise nur lesbaren Speicher mit einer bestimmten Speicherkapazität auslösbar ist, wobei der beschreibbare Speicher als dynamischer Speicher vorgesehen ist und die Speicherkapazität dynamisch auf den mindestens einen Sensor (8) verteilbar ist und wobei durch zumindest einen Schalter (12) zumindest drei Betriebsarten wählbar sind, wobei eine erste Betriebsart das Abspielen von Audiodateien aus dem nur lesbaren Speicher, eine zweite Betriebsart das Abspielen von Audiodateien aus dem beschreibbaren Speicher und eine dritte Betriebsart das Aufnehmen von eigenen Audiodateien in den beschreibbaren Speicher ermöglicht.

## Beschreibung

Die Erfindung betrifft ein Buch mit Audioausgabe und Aufnahmefunktion, insbesondere ein Buch, das über eine mittels Sensoren intuitiv bedienbare digitale Aufnahme- und Audioausgabefunktion verfügt.

Bücher, in die eine digitale Audioausgabefunktion integriert ist, sind im Stand der Technik bekannt. Ebenso sind Bücher bekannt, die neben der Audioausgabe auch über eine Aufnahmefunktion verfügen. Dabei wird die Ausgabe einer Audiodatei oder die Aufnahme einer Audiodatei in der Regel durch den Druck auf einen Sensor ausgelöst, wobei jedem Sensor eine bestimmte Speicherplatzgröße zugewiesen ist.

Mit der Aufnahme einer neuen Audiodatei wird die ursprünglich auf dem Speicherplatz befindliche Datei überschrieben. Wird für eine bestimmte Aufnahme ein größerer Speicherplatz benötigt als dem entsprechenden Sensor zugewiesen, so wird die Aufnahme bei Erreichen der diesem Sensor maximal zugewiesenen Speicherkapazität beendet, obwohl die den übrigen Sensoren zugewiesenen Speicherplätze gegebenenfalls noch Kapazitäten zur Verfügung stellen könnten.

Nachteilig an den bekannten Audiobüchern mit Aufnahmefunktion ist einerseits, dass der eingebaute Speicher nicht flexibel zur Verfügung gestellt wird. Andererseits ist die Zahl an Audiodateien dahingehend beschränkt, dass die ursprünglich vorgesehene Aufnahme durch eine neue Audioaufnahme überschrieben wird und anschließend nicht mehr zur Verfügung steht.

Zudem sollte die Bedienung eines solchen Audiobuches möglichst intuitiv erfolgen können und das Aufnahmeverfahren möglichst einfach gestaltet sein.

Es ist somit Aufgabe der Erfindung, ein Buch mit Audioausgabe und Aufnahmefunktion zur Verfügung zu stellen, das eine variable Speicherbelegung ermöglicht und bei dem zudem eine vorhandene Audioaufnahme nicht durch die Aufnahmefunktion überschrieben wird.

Ferner ist es Aufgabe der Erfindung, ein Buch mit Audioausgabe und Aufnahmefunktion zur Verfügung zu stellen, das eine intuitive Bedienung des Audiobuches durch eine besonders einfache Bedienbarkeit insbesondere zur Erstellung von Audioaufnahmen ermöglicht.

Gelöst wird diese Aufgabe durch eine Vorrichtung mit den Merkmalen des Anspruchs 1. Vorteilhafte Ausgestaltungen sind jeweils Gegenstand der abhängigen Ansprüche. Es ist darauf hinzuweisen, dass die in den Ansprüchen einzeln aufgeführten Merkmale auch in beliebiger und technologisch sinnvoller Weise miteinander kombiniert werden können und somit weitere Ausgestaltungen der Erfindung aufzeigen.

Ein erfindungsgemäßes Buch umfasst einen vorderen und einen hinteren Buchdeckel, einen Buchrücken, mindestens eine Buchseite und eine Elektronik mit mindestens einem Sensor vorzugsweise mindestens zwei Sensoren. Die Sensoren sind zur Erfassung des Drucks auf einen bestimmten Bereich einer Buchseite geeignet, wobei durch den Druck auf den Sensor je nach gewählter Betriebsart die Wiedergabe oder die Aufnahme einer diesem Sensor zuweisbaren Audiodatei aus einem zumindest teilweise beschreibbaren und teilweise nur lesbaren Speicher mit einer bestimmten Speicherkapazität auslösbar ist.

Die Elektronik des erfindungsgemäßen Buchs ist in dem vorderen und/oder dem hinteren Buchdeckel und/oder dem Buchrücken angeordnet. Sofern Anteile der Elektronik in einem oder mehreren dieser Bereiche verteilt sind, dann sind sie, wo notwendig, miteinander verbunden.

Vorzugsweise ist die Elektronik im Wesentlichen im hinteren Buchdeckel angeordnet, wobei die Sensoren in den entsprechenden Buchseiten angeordnet und mit der übrigen Elektronik verbunden sind. Optional umfasst das Buch auch Lichteffekte, die in allen Teilen des Buches angeordnet sein können, also sowohl in den Buchseiten als auch in zumindest einem der Buchdeckel oder dem Buchrücken.

Sofern die Anbringung von elektronischen Bauteilen an einer der Buchseiten oder einem der Buchdeckel vorgesehen ist, so umfasst die entsprechende Buchseite oder der entsprechende Buchdeckel vorzugsweise drei übereinander angeordnete Lagen. Die erste Lage entspricht der Vorderseite der Buchseite oder des Buchdeckels und die dritte Lage entspricht der Rückseite der Buchseite oder des Buchdeckels. Die zweite oder mittlere Lage ist vorzugsweise zumindest entlang der Seiten schlüssig zwischen der ersten und der dritten Lage angeordnet und umfasst, gegebenenfalls mit Aussparungen für die einzubettenden Bauteile, die Elektronik. Entsprechend der einzubettenden Bauteile der Elektronik sind die Größe der Aussparungen und auch die Dicke des Materials der zweiten Lage passend zu wählen.

Sind die einzubettenden Bauteile der Elektronik nur sehr dünn, wie beispielsweise die in den Seiten angeordneten Sensoren, dann kann die zweite Lage auch nur aus der entsprechenden Elektronik bestehen.

Die in den Buchseiten angeordneten Sensoren sind insbesondere kapazitive Druck- und/oder Berührungssensoren. Im Sinne der Erfindung werden für diese Sensoren die Begriffe "Berührungssensor" und "Drucksensor" synonym verwendet. Relevant ist hier vor allem, dass der Sensor geeignet ist, einen bestimmten Druck oder eine bestimmte Berührung des Nutzers zu erfassen. Insofern werden auch die Begriffe "Druck" und "Berührung" sowie "drücken" und "berühren" als gleichwertig im Sinne der Erfindung angesehen. Wichtig ist auch hierbei nur, dass durch eine entsprechende Handlung der entsprechende Sensor auslösbar ist.

Drückt der Nutzer des Buchs nun auf eine markierte Stelle auf einer aufgeschlagenen Seite des Buchs, so nimmt ein an dieser Stelle in der Seite angeordneter Sensor diesen Druck auf und eine diesem Sensor zugeordnete Audiodatei ertönt. Im Sinne dieser Erfindung werden alle möglichen Klänge wie Sprache, Musik, Töne, Geräusche etc. nachfolgend als Audiodatei bezeichnet.

Die Markierung eines Sensors auf der Seite kann beispielsweise farblich oder auch durch eine Aussparung an dieser Stelle erfolgen.

Jede Buchseite des erfindungsgemäßen Buchs, für die das Abspielen zumindest einer Audiodatei vorgesehen ist, umfasst einen solchen Sensor, der mit der übrigen Elektronik des Buchs verbunden ist. Dieser Sensor ist bevorzugt in die zweite Lage der Buchseite eingebettet. Sofern die Anbringung des Sensors aufgrund seiner Dimensionen keine zweite Lage mit Aussparungen erfordert, kann der Sensor auch einfach zwischen zwei Lagen in die Buchseite eingebracht werden. In dieser Variante wären die entsprechenden Buchseiten dann lediglich zweilagig.

Die Elektronik des erfindungsgemäßen Buchs umfasst zudem mindestens einen Schalter, über den eine von mindestens drei Betriebsarten wählbar ist. Vorzugsweise sind drei Betriebsarten wählbar, nämlich "Abspielen der vorgegebenen Audiodateien", "Abspielen der eigenen Audiodateien" und "Aufnahme der eigenen Audiodateien".

In einer bevorzugten Ausführungsform umfasst die Elektronik des Buchs zwei Schalter, wobei mit dem ersten Schalter zwei Betriebsarten auswählbar sind, nämlich "Audiowiedergabe" und "Audioaufnahme". Optional kann der erste Schalter auch eine Einstellung "Ausgeschaltet" umfassen.

Mit dem zweiten Schalter kann gewählt werden, welche Audiodateien abgespielt werden sollen, nämlich entweder "Wiedergabe aufgenommene Audiodateien" oder "Wiedergabe vorgegebene Audiodateien". Dabei können optional eine Vielzahl von selbst aufgenommenen Audiodateien oder eine Vielzahl von voreingespielten Audiodateien auswählbar sein.

In der Schalterstellung "Audiowiedergabe" und "Wiedergabe vorgegebene Audiodateien" können bei Druck auf die Sensoren die werksseitig fest eingespeicherten Audiodateien abgerufen werden.

In der Schalterstellung "Audiowiedergabe" und "Wiedergabe aufgenommene Audiodateien" können bei Druck auf die Sensoren die selbst aufgenommenen Audiodateien abgerufen werden.

In der Schalterstellung "Audioaufnahme" können über Druck auf die Sensoren eigene Audiodateien aufgenommen werden.

In der Schalterstellung "Audioaufnahme" kann pro Sensor eine Audiodatei selbst aufgenommen werden, indem der Sensor, für den eine eigene Audiodatei aufgenommen werden soll, zum Starten der Aufnahme gedrückt und gehalten wird, bis die Aufnahme beendet sein soll. Die Audioaufnahme erfolgt also so lange, wie der entsprechende Sensor gedrückt wird.

Alternativ kann auch vorgesehen sein, dass die Aufnahme durch einen ersten Druck auf den entsprechenden Sensor gestartet und durch einen zweiten Druck beendet wird.

Nach Beenden der Aufnahme wird die aufgenommene Audiodatei zur Kontrolle automatisch einmal abgespielt. Sofern die Audioaufnahme wiederholt werden soll, können die oben genannten Schritte beliebig oft wiederholt werden.

So kann für jeden Sensor eine eigene Audioaufnahme erstellt werden.

In einer Weiterentwicklung der Erfindung ist es auch denkbar, dass für jeden Sensor eine Vielzahl vorgegebener Audiodateien vorgesehen und/oder eine Vielzahl eigener Audiodateien erstellbar sind, die zur Wiedergabe oder Aufnahme über entsprechende Schalter auswählbar sind.

Nach Beenden der Audioaufnahmen kann der Schalter wieder in die Stellungen "Audiowiedergabe" oder "Ausgeschaltet" gebracht werden. Die eigenen Aufnahmen sind nun dauerhaft gespeichert und über die entsprechenden Sensoren abrufbar bis neue Audioaufnahmen erstellt werden.

Erfindungsgemäß wird für eine Audioaufnahme der Speicherplatz, der für eigene Audioaufnahmen insgesamt zur Verfügung steht, dynamisch auf die Sensoren verteilt, sodass für eine entsprechende eigene Audiodatei erfindungsgemäß eine flexible Speicherkapazität zur Verfügung steht.

Anders ausgedrückt stellt das erfindungsgemäße Audiobuch einen bestimmten Speicher zur Sicherung eigener Audiodateien zur Verfügung. Diese Audiodateien sind einem bestimmten Sensor fest zugeordnet, die Audiodateien sind jedoch an sich nicht in ihrer Größe limitiert. Vielmehr steht der gesamte verfügbare Speicher jeweils jeder Audiodatei zur Verfügung und somit kann man auch sagen, dass jedem Sensor dynamisch die noch verbleibende Speicherkapazität zugewiesen werden kann.

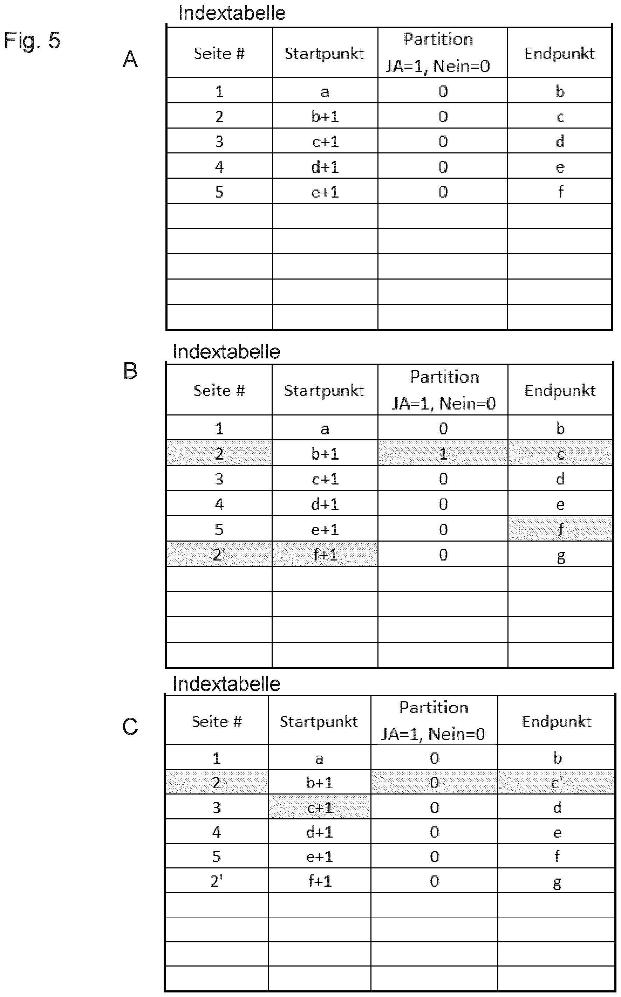

Entsprechend ist zur dynamischen Speicherverwaltung eine Index-Tabelle vorgesehen, in der der Startpunkt und der Endpunkt der jeweiligen Audioaufnahme gespeichert sind. Bei Druck auf einen Sensor erkennt der IC-Controller, welcher Sensor gedrückt wurde und durchsucht die Indextabelle, um die entsprechende Audiodatei aus dem Speicher abzurufen, und gibt sie wieder. Eine genauere Darstellung findet sich in der folgenden Figur 5 und der dazugehörigen Beschreibung.

Es ist denkbar, dass bei der dynamischen Zuweisung der Speicherkapazität für jeden Sensor ein Mindestspeicher reserviert bleibt, damit für jeden Sensor initial zumindest eine kurze Audioaufnahme möglich ist.

Bei vergleichbaren vorbekannten Büchern war jedem Berührungssensor jeweils eine feste Speicherkapazität zugeordnet. Entsprechend konnte nur eine Audiodatei bestimmter maximaler Länge aufgenommen werden, selbst wenn die Speicherkapazität anderer Sensoren noch nicht vollkommen ausgeschöpft war.

Die Elektronik des erfindungsgemäßen Buchs umfasst entsprechend vorzugsweise zumindest einen Mikroprozessor, mindestens einen Lautsprecher, mindestens ein Mikrofon, mindestens einen Schalter zur Wahl der Betriebsart, eine Stromversorgung, einen dynamisch an die Sensoren zuweisbaren Speicher, mindestens einen Sensor zur Auslösung einer Audiodatei bei Druck.

Wird das Buch aufgeschlagen und auf einer Seite durch entsprechenden Druck ein Sensor ausgelöst, so löst der Mikroprozessor je nach ausgewählter Betriebsart entweder die Wiedergabe der entsprechenden Audiodatei aus oder lässt die Aufnahme einer Audiodatei zu.

Der Nutzer drückt also auf einer aufgeschlagenen Seite auf ein vorgesehenes, markiertes Felder und aktiviert so den entsprechenden darunterliegenden Sensor.

Welche Audiodatei bei Druck auf einen Sensor abgespielt oder aufgenommen wird, hängt entsprechend nicht allein von dem aktivierten Sensor ab, sondern auch von der über den oder die Schalter gewählten Betriebsart.

Die Audiodateien werden in einem internen Speicher abgelegt. Die Audiodateien liegen zum einen fest eingespeichert vor, wobei Audioaufnahmen zusätzlich durch den Nutzer neu erstellt werden können. Neue Audiodateien können dabei alternativ auch über eine optionale Schnittstelle und/oder über ein optionales Mikrofon in den internen Speicher des Buchs geladen bzw. eingegeben werden.

Ein erfindungsgemäßes Buch ermöglicht das Aufnehmen eigener Audiodateien beispielsweise mit einem Verfahren umfassend die folgenden Schritte:
(A) Auswählen der Betriebsart zur Aufnahme eigener Audiodateien mit dem entsprechenden Schalter;
(B) Öffnen der Buchseite, für die eine Audiodatei erstellt werden soll;
(C) Aktivieren des Sensors auf der Buchseite, für den eine Audiodatei erstellt werden soll;
(D) Aufnahme der Audiodatei;
(E) optional Anhören der Audiodatei nach dem Beenden der Aufnahme;
(F) optionales Wiederholen der Schritte (A) bis (E) für die gleiche oder weitere Seiten oder Sensoren.

Das Aktivieren des Sensors kann, wie zuvor beschrieben, durch einmaliges Drücken zu Beginn und zum Ende der Aufnahme erfolgen oder durch das Gedrückt-Halten des Sensors während der gesamten Aufnahme.

Eine Schnittstelle zum kabellosen oder kabelgebundenen Datenaustausch von Audiodateien mit externen Geräten wie Computern, Smartphones, Laptops, Tablets etc., kann optional vorgesehen sein. So ist beispielsweise auch eine externe Verwaltung der Audiodateien denkbar, die eine einfache und übersichtliche Zuordnung einzelner Audiodateien zu bestimmten Sensoren ermöglicht.

Es ist auch denkbar, dass bestimmte Audiodateien beim Aufschlagen des Buches automatisch abgespielt werden und andere Audiodateien erst bei Druck auf einen Sensor abgespielt werden.

Die Aufteilung der Elektronik auf den vorderen und/oder hinteren Buchdeckel und/oder Buchrücken wählt der Fachmann entsprechend der geplanten Verwendung oder auch nach rein gestalterischen Aspekten.

In einer alternativen Ausgestaltung des erfindungsgemäßen Buchs ist es denkbar, dass zumindest Teile der Elektronik in einem Gehäuse angeordnet sind. Insbesondere betrifft dies solche Bauteile, die in der bisher beschriebenen Ausführungsform in den Buchdeckeln angeordnet sind, wie beispielsweise Batterien, Lautsprecher, Hauptplatine, Mikrofon oder Schalter. Zumindest die Drucksensoren sind vorzugsweise weiterhin im Buchdeckel angeordnet, da diese durch den Benutzer zu aktivieren und entsprechend nicht im Gehäuse anzuordnen sind.

Das Gehäuse ist vorzugsweise innenliegend im Buch an der Vorder- bzw. Innenseite des hinteren Buchdeckels angeordnet. Alternativ ist auch eine Anordnung des Gehäuses innenliegend an der Rück- bzw. Innenseite des vorderen Buchdeckels denkbar. In jedem Fall ist das Gehäuse ausreichend an dem jeweiligen Buchdeckel zu fixieren.

Das erfindungsgemäße Buch weist gegenüber dem Stand der Technik den Vorteil auf, dass es insbesondere durch die dynamische Speicherbelegung eine verbesserte Nutzung des verbauten Speichers ermöglicht. So ist auch die Aufnahme vergleichsweise langer Audiodateien bei insgesamt begrenztem Speicher möglich. Zudem verhindert die Option, fest eingespeicherte und eigene Audiodateien zu verwalten, den Nachteil bekannter Bücher, die ursprüngliche Audiodatei durch eigene Aufnahmen überspielen zu müssen.

Ferner ist das Buch durch die intuitive Benutzerführung einfach in der Handhabung.

Die Erfindung sowie das technische Umfeld werden nachfolgend anhand der Figuren näher erläutert. Es ist darauf hinzuweisen, dass die Figuren eine besonders bevorzugte Ausführungsvariante der Erfindung zeigen. Die Erfindung ist jedoch nicht auf die gezeigte Ausführungsvariante beschränkt. Insbesondere umfasst die Erfindung, soweit es technisch sinnvoll ist, beliebige Kombinationen der technischen Merkmale, die in den Ansprüchen aufgeführt oder in der Beschreibung als erfindungsrelevant beschrieben sind.

Es zeigen:
- Fig. 1: eine schematische Ansicht A der Vorderseite bzw. B der Rückseite des erfindungsgemäßen Buchs;
- Fig. 2: eine schematische Ansicht des erfindungsgemäßen Buchs im teilweise aufgeschlagenen Zustand;
- Fig. 3: eine aufgeschlagene Seite des erfindungsgemäßen Buchs;
- Fig. 4: die Innenansicht des geöffneten hinteren Buchdeckels mit der darin angeordneten Elektronik;
- Fig. 5: die Verwaltung des dynamischen Speichers.

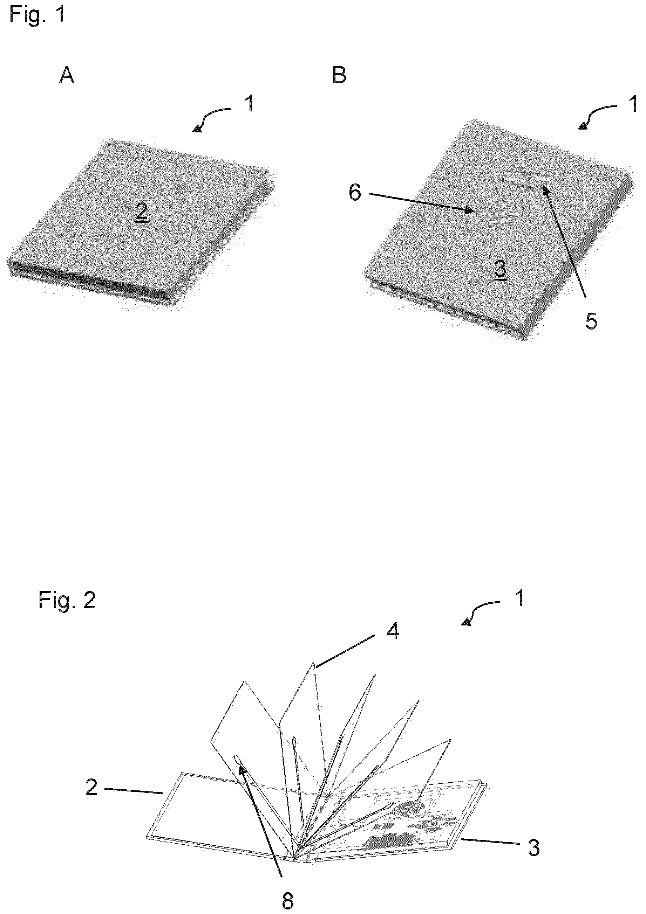

Fig. 1A zeigt eine schematische Ansicht der Vorderseite des vorderen Buchdeckels 2 des erfindungsgemäßen Buchs 1 und Fig. 1B zeigt eine schematische Ansicht der Rückseite des hinteren Buchdeckels 3 des erfindungsgemäßen Buchs 1. Vorzugsweise sind in der Rückseite des hinteren Buchdeckels 3 ein Zugang zum Batteriefach 5 und Öffnungen 6 insbesondere für einen Lautsprecher zur besseren Akustik angeordnet. Ferner können weitere Öffnungen zur Bedienung von Schaltern zur Wahl der Betriebsart vorgesehen sein.

Fig. 2 zeigt eine schematische Ansicht des erfindungsgemäßen Buchs 1 im teilweise aufgeschlagenen Zustand mit dem vorderen Buchdeckel 2, dem hinteren Buchdeckel 3 und den zwischen vorderem und hinterem Buchdeckel 2, 3 liegenden Buchseiten 4. In den Buchseiten 4 sind berührungsbeziehungsweise druckempfindliche Sensoren 8 zur Aktivierung von Audiodateien vorgesehen. Die Sensoren 8 sind mit der benötigten Elektronik verbunden, wobei die Elektronik vorwiegend im hinteren Buchdeckel 3 angeordnet ist.

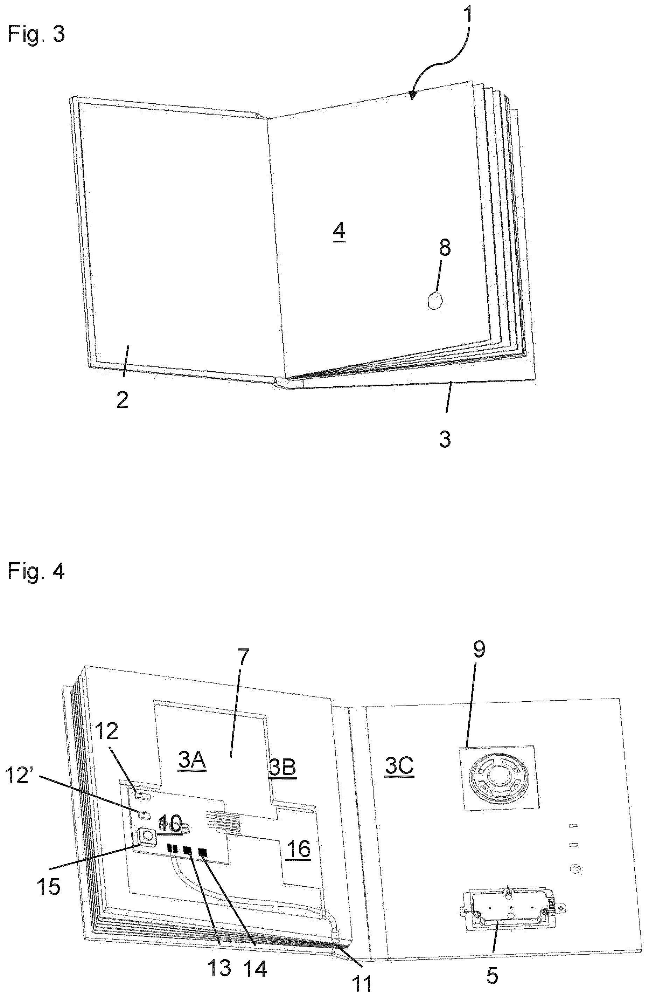

Fig. 3 zeigt eine schematische Ansicht des auf einer Seite 4 aufgeschlagenen Buchs 1. In der Seite 4 ist ein Sensor 8 zur Aktivierung einer Audiodatei vorgesehen. Die Position des Sensors 8 kann durch verschiedene Mittel markiert sein, beispielsweise farblich oder durch eine Aussparung in der Seite.

Fig. 4 zeigt eine schematische Ansicht des Aufbaus des hinteren Buchdeckels 3 einer bevorzugten Variante des erfindungsgemäßen Buchs 1. Der hintere Buchdeckel 3 umfasst dabei eine erste Lage 3A, eine zweite Lage 3B und eine dritte Lage 3C. Dabei entsprechen die erste und die dritte Lage 3A, 3C der Vorder- bzw. der Rückseite des hinteren Buchdeckels 3. Die zweite Lage 3B ist zwischen der ersten und der dritten Lage 3A, 3C angeordnet und vorzugsweise fest mit diesen verbunden, beispielsweise wird diese zwischen der ersten und der dritten Lage 3A, 3C eingeleimt. Die zweite Lage 3B umfasst eine oder auch mehrere Aussparungen 7, in denen verschiedene elektronische Teile angeordnet sein können, insbesondere Batterien 5 zur Energieversorgung, Lautsprecher 9, Platinen 10 mit Elementen zur Steuerung und Speicherung der Audiodateien. Auch können hier ein Mikrofon 11 zur Aufnahme eigener Audiodateien vorgesehen sein, ein Mikroprozessor 13 zur Steuerung, Ein Lautstärkeregler 15, Speicherelemente 14, externe Anschlüsse zur kabellosen oder kabelgebundenen Kommunikation bzw. Datenübertragung mit externen Geräten, ein erster Schalter 12 zur Wahl bestimmter Betriebsmodi wie beispielsweise Aus oder Aufnahme oder Wiedergabe, ein zweiter Schalter 12' zur Wahl der selbst aufgenommenen Audiodateien oder der voreingestellten Audiodateien. Insbesondere sind hier auch die Verbindungen 16 zu den Sensoren 8 vorgesehen.

Fig. 5 zeigt das erfindungsgemäße Verfahren der dynamischen Speicherzuordnung mit einer Index-Tabelle. Figur 5A zeigt anhand der Index-Tabelle den Zustand des Speichers beim ersten eigenen Erstellen von Audiodateien beispielhaft für ein Buch mit fünf Seiten 1 bis 5. Jeder Seite ist ein Speicherplatz mit einem Startpunkt (a, b+1, c+1, d+1, e+1 etc.) und einem Endpunkt (b, c, d, e, f etc.) zugewiesen. Zudem ist für jeden Speicherplatz vermerkt, ob dieser partitioniert ist oder nicht (JA=1; NEIN=0).

Figur 5B zeigt anhand der Index-Tabelle den Zustand des Speichers nach dem erneuten Aufnehmen einer oder mehrerer Audiodateien, wobei beispielhaft die neue Audiodatei für Seite 2 länger ist als die ursprünglich aufgenommene Audiodatei 2. In diesem Fall wird mehr Speicherplatz für die Audiodatei benötigt und die Datei muss partitioniert werden. Entsprechend ändert sich der Partitionsindex von "0" zu "1". Die neue Aufnahme für Seite 2 beginnt bei b+1 und endet zunächst bei c, um den ursprünglichen Speicherplatz wieder voll auszunutzen. Der Partitionsindex ist nun jedoch auf 1 gesetzt, sodass der nächste verfügbare Speicherplatz gesucht wird, der mit 2' markiert ist. Die Aufnahme für Seite 2 wird nun von dieser Stelle f+1 bis g fortgesetzt.

Figur 5C zeigt anhand der Index-Tabelle den Zustand des Speichers nach dem erneuten Aufnehmen einer oder mehrerer Audiodateien, wobei beispielhaft die neue Audioaufnahme für Seite 2 kürzer ist als die zuvor aufgenommene Audiodatei für Seite 2. In diesem Fall wird weniger Speicherplatz für die Audiodatei benötigt und die Datei muss nicht mehr partitioniert werden. Entsprechend ändert sich der Partitionsindex der neuen Aufnahme 2 wieder von "1" zu "0", und es wird lediglich ein neuer Endpunkt c' vergeben. Der gegebenenfalls zwischen den Punkten c`+1 und c noch verfügbare Speicherplatz kann für andere Audiodateien genutzt werden. Ein Defragmentierungsprogramm kann den Speicher im weiteren Verlauf in regelmäßigen Intervallen neu gruppieren, um Partitionen zu beseitigen. Nach der erfolgten Defragmentierung entspricht die Indextabelle wieder dem in Abbildung 5A dargestellten Zustand.

### Bezugszeichenliste

- 1: Erfindungsgemäßes Buch
- 2: Vorderer Buchdeckel
- 3: Hinterer Buchdeckel (A: erste Lage, B: zweite Lage, C: dritte Lage)
- 4: Buchseite
- 5: Batteriefach/Stromversorgung
- 6: Öffnungen
- 7: Aussparung
- 8: Sensor
- 9: Lautsprecher
- 10: Hauptplatine
- 11: Mikrofon
- 12: erster Schalter (Wiedergabe-Aufnahme-Wahlschalter, optional Aus)
- 12': zweiter Schalter (Wahlschalter zwischen selbst aufgenommenen und voreingestellten Audiodateien)
- 13: Mikroprozessor
- 14: Speicherelement
- 15: Lautstärkeregler
- 16: Verbindungselement zu Sensoren

## Patentansprüche

1. Buch mit einer Audioausgabe und Audioaufnahmefunktion mit einem vorderen und einem hinteren Buchdeckel (2, 3), einem Buchrücken, mindestens einer Buchseite (4) und mit einer Elektronik, die mindestens einen Sensor (8) umfasst, die in mindestens einer Buchseite (4) oder einem Buchdeckel (2, 3) angeordnet sind, wobei durch den Druck auf einen Sensor (8) die Wiedergabe oder die Aufnahme einer diesem Sensor (8) zuweisbaren Audiodateien aus einem zumindest teilweise beschreibbaren und teilweise nur lesbaren Speicher mit einer bestimmten Speicherkapazität auslösbar ist, **dadurch gekennzeichnet, dass** der beschreibbare Speicher als dynamischer Speicher vorgesehen ist und die Speicherkapazität dynamisch auf den mindestens einen Sensor (8) verteilbar ist und wobei durch zumindest einen Schalter (12) zumindest drei Betriebsarten wählbar sind, wobei eine erste Betriebsart das Abspielen von Audiodateien aus dem nur lesbaren Speicher, eine zweite Betriebsart das Abspielen von Audiodateien aus dem beschreibbaren Speicher und eine dritte Betriebsart das Aufnehmen von eigenen Audiodateien in den beschreibbaren Speicher ermöglicht.

2. Buch mit einer Audioausgabe und Audioaufnahmefunktion nach Anspruch 1, **dadurch gekennzeichnet, dass** die Sensoren (8) kapazitive Drucksensoren sind.

3. Buch mit einer Audioausgabe und Audioaufnahmefunktion nach einem der vorherigen Ansprüche, **dadurch gekennzeichnet, dass** die Elektronik des Buchs (1) zudem mindestens einen Mikroprozessor (13), mindestens einen Lautsprecher (9), eine Stromversorgung (5), einen Speicherelement (14) und einen Lautstärkeregler (15) umfasst.

4. Buch mit einer Audioausgabe und Audioaufnahmefunktion nach einem der vorherigen Ansprüche, **dadurch gekennzeichnet, dass** das Buch (1) ein internes Mikrofon (11) umfasst.

5. Buch mit einer Audioausgabe und Audioaufnahmefunktion nach einem der vorherigen Ansprüche, **dadurch gekennzeichnet, dass** das Buch (1) eine kabellose und/oder kabelgebundene Schnittstelle zur Kommunikation und/oder Datenübertragung zu externen elektronischen Geräten umfasst.

6. Buch mit einer Audioausgabe und Audioaufnahmefunktion nach einem der vorherigen Ansprüche, **dadurch gekennzeichnet, dass** der dynamische Speicher in Form einer Indextabelle vorgesehen ist, wobei jedem Sensor (8) eine Audiodatei anhand ihres Anfangs- und Endpunkts in der Indextabelle zuweisbar ist.

7. Buch mit einer Audioausgabe und Audioaufnahmefunktion nach einem der vorherigen Ansprüche, **dadurch gekennzeichnet, dass** das Aufnehmen eigener Audiodateien folgende Schritte umfasst:
(A) Auswählen der Betriebsart zur Aufnahme eigener Audiodateien mit dem entsprechenden Schalter (12);
(B) Öffnen der Buchseite, für die eine Audiodatei erstellt werden soll;
(C) Aktivieren des Schalters auf der Buchseite, für den eine Audiodatei erstellt werden soll;
(D) Aufnahme der Audiodatei;
(E) optional Anhören der Audiodatei nach dem Beenden der Aufnahme;
(F) optionales Wiederholen der Schritte (A) bis (E) für die gleiche oder weitere Seiten oder Sensoren.
